# EUROPEAN PATENT SPECIFICATION

(11) **EP 0 605 095 B1**
(45) Date of publication and mention of the grant of the patent: **31.07.1996**
(21) Application number: 93308875.9
(22) Date of filing: 05.11.1993
(51) Int. Cl.: G03F 7/30

(54) **Apparatus and method for preparing a developer solution**
Vorrichtung und Verfahren zur Vorbereitung einer Entwicklerlösung
Appareil et méthode de préparation pour une solution de développement

(30) Priority: 28.12.1992 JP 347645/92
(43) Date of publication of application: 06.07.1994
(73) Proprietor: SUMITOMO CHEMICAL COMPANY, LIMITED, Osaka-shi, Osaka (JP)
(72) Inventor: Taguchi, Satoshi, Ichihara-shi, Chiba (JP); Suetsugu, Masumi, Ichihara-shi, Chiba (JP); Nagase, Tsutomu, Sodegaura-shi, Chiba (JP); Nakagawa, Norikazu, Ichihara-shi, Chiba (JP)
(74) Representative: Dixon, Donald Cossar

(56) References cited:
- EP-A- 0 578 505
- DE-A- 4 003 119
- DATABASE INSPEC INSTITUTE OF ELECTRICAL ENGINEERS, STEVENAGE, GB Inspec No. 2343545 DRESS W B 'A high resolution ultrasonic densitometer'
- PATENT ABSTRACTS OF JAPAN vol. 8, no. 103 (E-244)(1540) 15 May 1984 & JP-A-59 021 022 (NIPPON ZEON K. K.)
- PATENT ABSTRACTS OF JAPAN vol. 17, no. 658 (P-1654)6 December 1993 & JP-A-05 216 241 (MITSUBISHI GAS CHEM CO INC) 27 August 1993
- PATENT ABSTRACTS OF JAPAN vol. 13, no. 208 (C-596)16 May 1898 & JP-A-01 027 624 (HITACHI PLANT ENG & CONSTR) 30 January 1989
- PATENT ABSTRACTS OF JAPAN vol. 014, no. 207 (P-1043)26 April 1990 & JP-A-02 046 464 (SEIKO EPSON CORP) 15 February 1990

## Description

The present invention relates to apparatus for preparing a developer solution and to a method wherein this apparatus is used.

Lithography is used to form the fine patterns required for the production of an LCD (Liquid Crystal Display) or LSI (Large Scale Integration), and a photoresist is used for the lithography. As types of photoresist, there are a positive-working type and a negative-working type of photoresist; since the positive-working type photoresist is particularly excellent in dimensional accuracy and resolving power, the positive-working type is generally used.

An aqueous solution of an inorganic or organic alkali is used as a developer for the positive working type photoresist, but to prevent the occurrence of staining with an alkali metal, an aqueous organic alkali solution, in particular, an aqueous solution of tetramethylammonium hydroxide, is suitably used, and the concentration thereof at use is as low as about 2.4% by weight. However, the concentration of an aqueous solution of tetramethylammonium hydroxide produced as an undiluted developer solution is usually from about 5 to 40% by weight and hence it is necessary upon use to dilute the undiluted developer solution with pure water.

Now, for correctly forming fine patterns, it is important to develop the light-exposed resist with good accuracy and it is necessary for this purpose that the composition of the developer used is strictly controlled at a definite concentration.

Hitherto, the concentration and the composition of the developer are correctly controlled by the developer manufacturer and the developer is prepared by the manufacturer and is supplied to users such as the makers of LSI and LCD. Considering that the concentration of an alkali which is the main component of the developer is about 2.4% by weight as described above but when the undiluted developer solution is obtained as an aqueous solution having a concentration of from about 5 to 40% by weight, there is a problem that when the developer manufacturer supplies the diluted developer solution to the users, the costs for the container and the transportion for transporting the developer from the developer manufacturers to the users increase. To overcome this problem, the developer manufacturer supplies the undiluted developer solution to the users, and the users dilute the undiluted developer solution. However, it is necessary that the concentration of the developer after dilution is strictly adjusted to a definite concentration and that the developer is kept and controlled at that concentration, and also from the standpoint of industrial practice it is required to practice the above procedure quickly and in labor-saving manner.

Even under these circumstances, a developer preparing apparatus and a developer preparing method, which can strictly adjust the concentration of the developer at a definite value and keep and control the concentration of the developer, and also can practice the procedure quickly and with labor-saving have not yet been realized.

DE-A-4003119 discloses an apparatus and method for the preparation of a developer solution without using an ultrasonic densitometer and with a developer solution electroconductivity in the optimum range of 2-100 µS/cm.

The 1983 Ultrasonics Symposiumn Proceedings (Atlanta, GA, USA 31 Oct - 2 Nov 1983 pp 287-290, Vol. 1) discloses a high resolution ultrasonic densitometer for possible application in on-line process maintaining, as a hand-held density probe for battery charge state indication, or as a precise inventory control for such diverse fluids as uranium salt solutions in accountability storage and gasoline in service station storage tanks.

Patent Abstract of Japan Vol. 8 No 103 (E-244) (1540) 15 May 1984 and JP-A-59021022 disclose a method of filling a vessel with resist developer or rinse liquid by operating an electromagnetic valve with a level switch.

Patent Abstract of Japan Vol. 014, No. 207 (p-1043) 26 April 1990 and JP-A-02046464 disclose a developing method using tetramethylammonium hydroxide.

Thus, an object of the present invention is to provide an apparatus and method for preparing a developer, which can strictly adjust the concentration of the developer at a definite value and keep and control the developer at the concentration, and also can practice this procedure quickly and with labor-saving.

We have discovered that the object can be attained by the present invention as described hereinbelow.

According to one embodiment of the present invention, there is provided a developer preparing apparatus for obtaining a developer containing developer components at a definite concentration by mixing an undiluted developer solution with pure water, comprising a mixing bath equipped with a means for receiving and mixing the undiluted developer solution and pure water, an ultrasonic densitometer for measuring the concentration of the developer components contained in the developer in the mixing bath, and flow rate controlling means for controlling the supplying flow rate of the undiluted developer solution and/or pure water into the mixing bath by the output signal from the ultrasonic densitometer, and a storage tank for receiving and storing the developer containing the developer components of the definite concentration in the mixing bath.

According to another embodiment of the present invention, there is provided a developer preparing method for preparing a developer containing developer components of a definite concentration by mixing an undiluted developer solution and pure water, which comprises using the above-described developer preparing apparatus, receiving and mixing the undiluted developer solution and pure water in the mixing bath, measuring the concentration of the developer components contained in the developer in the mixing bath by means of the ultrasonic densitometer, controlling the supplying flow rate of the undiluted developer solution and/or pure water into the mixing bath by putting the output signal from the ultrasonic densitometer in the flow rate controlling means to provide the developer containing the developer components of the definite concentration in the mixing bath, and supplying the developer into the storage tank and storing it therein.

The present invention is described in more detail below.

There is no particular restriction on the developer used in the present invention, but suitable examples of the developer are an aqueous solution of an inorganic alkali and an aqueous solution of an organic alkali. From the standpoint of capacity of producing recent types of fine LSI, an aqueous organic alkali solution having a very small content of metals is suitable and an aqueous solution of tetramethylammonium hydroxide is particularly preferred. In addition, the undiluted developer solution used in the present invention is obtained as an aqueous solution containing the developer components usually in amount of from 5 to 40% by weight. Also, by diluting the undiluted developer solution with pure water according to the present invention, a developer the concentration of which is strictly adjusted to a definite concentration of about 2.4% by weight is obtained.

The pure water which is preferably used in the present invention is pure water having a metal ion content of not more than a few ppb, and so-called ultra-pure water having a metal ion content of 0.1 ppb or less is more preferred.

In the present invention, there is used a mixing bath equipped with a means for receiving and mixing the undiluted developer solution and pure water. A specific example thereof is a mixing bath having an inlet for the undiluted developer solution, an inlet for pure water, and a stirring means.

Examples of the stirring method are a method of using a stirrer fitted inside the mixing bath, a method of drawing out a part of the developer in the mixing bath by a pump and circulating it into the mixing bath again, and a method of disposing a line mixer in the circulating line in the above circulating method. Furthermore, before supplying the undiluted developer solution and pure water into the mixing bath, they are mixed in a mixing apparatus such as a line mixer and thereafter the mixture may be supplied into the mixing bath. This method is preferable from the standpoint that the concentration of the developer in the mixing bath becomes uniform.

In the present invention, an ultrasonic densitometer is used to measure the concentration of the developer components contained in the developer in the mixing bath. There is no particular restriction on the ultrasonic densitometer and any ultrasonic densitometer which can correctly measure the concentration of the developer components can be used. For example, it is preferred that the frequency used is several MHz, the liquid-contact portion is composed of SUS (stainless steel) or a fluorine-containing polymer such as ptfe (e.g. Teflon, trade mark of E.I. du Pont de Nemours & Co., Ltd.), and the ultrasonic densitometer is equipped with a temperature-measuring portion and an ultrasonic wave transmitting and receiving portion, and also is equipped with a function capable of automatically correcting the measurement value to the temperature at measurement by the calibration curve previously obtained using a developer having a predetermined concentration and a temperature change compensating apparatus.

The ultrasonic densitometer used in the present invention must have a function capable of transmitting the measured value as an output signal. This is because it is necessary to control the supplying flow rate of the undiluted developer solution and/or pure water to the mixing bath by means of the output signal.

The measurement terminal of the ultrasonic densitometer may be disposed in the developer in the mixing bath, may be disposed in the above-described circulation line, or may be disposed in a measuring sampling line for sampling a small amount of the developer in the mixing bath and recycling it into the mixing bath.

In the present invention, it is necessary to use a flow rate-controlling means for controlling the supplying flow rate of the undiluted developer solution and/or pure water into the mixing bath by the output signal from the ultrasonic densitometer. There is no particular restriction on the type of flow rate controlling means; a means having a function of controlling the supplying flow rate of the undiluted developer solution and/or pure water into the mixing bath in accordance with the deviation between the concentration of the developer components in the developer in the mixing bath obtained as the output signal from the ultrasonic densitometer and the desired concentration of the developer components may suitably be used. Also, by providing a load cell for detecting the weight of the developer in the mixing bath and by controlling the supplying flow rate of the undiluted developer solution and/or pure water into the mixing bath based on the signal corresponding to the weight thereof and the deviation described above, a more precise and rapid automatic preparation of the developer becomes possible.

The developer mixed in the mixing bath, i.e. having the developer components of the definite concentration obtained by the method described above, is then stored in the storage tank and, when needed, is taken out from the storage tank for use.

The portions of the apparatus of the present invention which are contacted with the developer are preferably composed of a fluorine resin such as ptfe., a polyolefin series resin, or a material coated with the above-described resin, so as to prevent the contamination of the developer by traces of a metal.

The present invention is illustrated by the following example.

### Example

A mixing bath vessel having a volume of 1 m³ and having a stirrer was provided. The inside portion of the mixing bath and the portion of the stirrer to be contacted with the developer were all made of ptfe. Each supply line for the undiluted developer solution and pure water was a ptfe pipe and both lines were united with each other before entering the mixing bath and thereafter, the united line was connected to the mixing bath through a line mixer. Each of the supplying lines of the undiluted developer solution and pure water into the mixing bath was equipped with a flow rate control valve as means for controlling the flow rate and each flow rate control valve could control the flow rate of the undiluted developer solution or pure water according to the output signal from the ultrasonic densitometer. The ultrasonic densitometer was disposed in the line for taking out a part of the developer in the mixing bath, and the developer after the concentration thereof was measured was recycled into the mixing bath. Also, an inlet line was fitted to the mixing bath, whereby the developer thus prepared could be sent to the storage tank.

As the undiluted developer solution, an aqueous solution of about 15% by weight of tetramethylammonium hydroxide was used. After mixing the undiluted developer solution and pure water by the above-described line mixer, the mixture was supplied into the mixing bath. The stirrer of the mixing bath was rotated and the mixture supplied in the mixing bath was thus sufficiently stirred and mixed in the mixing bath.

Part of the developer in the mixing bath was sent to the line in which the ultrasonic densitometer was disposed, wherein the concentration of tetramethylammonium hydroxide in the developer was measured and at the same time, the output signal from the ultrasonic densitometer was sent to the flow rate controlling means of each of the supplying lines of the undiluted developer solution and pure water through a controller, and by automatically controlling the extent to which the flow rate control valves were open, the flow rates of the undiluted developer solution and pure water were controlled.

As a result thereof, the concentration of the developer in the mixing bath was maintained at 2.381% by weight for the operation period of 30 minutes and over the total prepared amount by volume of 0.8 m³, which showed that the developer could be prepared within an error of 0.04% to the desired concentration of 2.380% by weight. Furthermore, during the procedure the operation was all automated, and thus the method of the present invention was very excellent for labor-saving.

As described above, by the present invention we provide an apparatus and method for preparing a developer which can strictly prepare the developer at a definite value and keep and control the developer at the desired concentration, and also can operate quickly and with labor-saving.

## Claims

1. Apparatus for preparing a developer so as to obtain a developer containing developer components having a definite concentration by mixing an undiluted developer solution and pure water, comprising a mixing bath equipped with a means for receiving and mixing an undiluted developer solution and pure water, an ultrasonic densitometer for measuring the developer components contained in the developer in the mixing bath, a flow rate controlling means for controlling the supplying flow rate of the undiluted developer solution and/or pure water into the mixing bath according to the output signal from the ultrasonic densitometer, and a storage tank for receiving from the mixing bath and storing the developer containing the developer components having the definite concentration.

2. Apparatus as claimed in Claim 1, which includes a load cell for detecting the weight of the developer in the mixing bath.

3. A method of preparing a developer containing developer components having a definite concentration by mixing an undiluted developer solution and pure water, which comprises using the developer preparing apparatus of Claim 1 or 2, supplying and mixing an undiluted developer solution and pure water in the mixing bath, measuring the concentration of the developer components contained in the developer in the mixing bath by the ultrasonic densitometer, controlling the supplying flow rate of the undiluted developer solution and/or pure water into the mixing bath by inputting the output signal from the ultrasonic densitometer to the flow rate controlling means to provide the developer containing the developer components of a definite concentration in the mixing bath, and supplying the developer to the storage tank and storing it therein.

4. A method as claimed in Claim 3, wherein the output signal from the ultrasonic densitometer and the output signal from the load cell are inputted into the flow rate controlling means.

5. The apparatus of Claim 1 or developer preparing method of Claim 3 or 4, wherein the undiluted developer solution is an aqueous solution of tetramethylammonium hydroxide.

## Patentansprüche

1. Vorrichtung zum Herstellen eines Entwicklers, durch die ein Entwickler mit einer vorgegebenen Konzentration darin enthaltener Entwicklerkomponenten erhalten wird, indem eine unverdünnte Entwicklerlösung mit Reinwasser vermischt wird, wobei die Vorrichtung aufweist: ein Mischbad mit einer Einrichtung zum Aufnehmen einer unverdünnten Entwicklerlösung und zum Aufnehmen von Reinwasser und zum Mischen der unverdünnten Entwicklerlösung mit dem Reinwasser, ein Ultraschall-Densitometer zum Messen der im Entwickler im Mischbad enthaltenen Entwicklerkomponenten, eine Durch-flußmengensteuerungseinrichtung zum Steuern der Zufuhrdurchflußmenge der dem Mischbad zugeführten unverdünnten Entwicklerlösung und/oder des dem Mischbad zugeführten Reinwassers gemäß dem Ausgangssignal des Ultraschall-Densitometers und einen Speicherbehälter, dem der Entwickler mit den darin in einer vorgegebenen Konzentration enthaltenen Entwicklerkomponenten vom Mischbad zugeführt und in dem der Entwickler gespeichert wird.

2. Vorrichtung nach Anspruch 1, ferner mit einer Meßzelle zum Erfassen des Gewichts des Entwicklers im Mischbad.

3. Verfahren zum Herstellen eines Entwicklers mit einer vorgegebenen Konzentration von darin enthaltenen Entwicklerkomponenten durch Vermischen einer unverdünnten Entwicklerlösung mit Reinwasser, wobei das Verfahren die Schritte aufweist: Verwenden der Vorrichtung zum Herstellen eines Entwicklers nach Anspruch 1 oder 2, Einleiten einer unverdünnten Entwicklerlösung und Einleiten von Reinwasser in ein Mischbad und Vermischen der unverdünnten Entwicklerlösung mit dem Reinwasser im Mischbad, Messen der Konzentration der im Entwickler im Mischbad enthaltenen Entwicklerkomponenten durch das Ultraschall-Densitometer, Steuern der Zufuhrdurchflußmenge der dem Mischbad zugeführten unverdünnten Entwicklerlösung und/oder des dem Mischbad zugeführten Reinwassers, indem das Ausgangssignal des Ultraschall-Densitometers der Durchflußmengensteuerungseinrichtung zugeführt wird, um den Entwickler mit einer festgelegten Konzentration der Entwicklerkomponenten im Mischbad herzustellen, und Einleiten des Entwicklers in den Speicherbehälter und Speichern des Entwicklers im Speicherbehälter.

4. Verfahren nach Anspruch 3, wobei das Ausgangssignal des Ultraschall-Densitometers und das Ausgangssignal der Meßzelle der Durchflußmengensteuerungseinrichtung zugeführt werden.

5. Vorrichtung nach Anspruch 1 oder Verfahren nach Anspruch 3 oder 4, wobei die unverdünnte Entwicklerlösung eine wässerige Lösung aus Tetramethylammoniumhydroxyd ist.

## Revendications

1. Appareil de préparation d'un développateur, qui permet d'obtenir un développateur dont les composants ont une concentration définie grâce au mélange d'une solution de développement non diluée avec de l'eau pure, constitué par un bain de mélange équipé d'un moyen destiné à recevoir et mélanger la solution de développement non diluée et l'eau pure, d'un densitomètre ultrasonore qui mesure la concentration des composants du développement contenus dans le développateur dans le bain de mélange, d'un moyen de contrôle du débit qui contrôle le débit d'alimentation de la solution de développement non diluée et/ou de l'eau pure dans le bain de mélange grâce au signal de sortie du densitomètre ultrasonore et d'une cuve de stockage destinée à recevoir, depuis le bain de mélange, et à conserver le développateur dont les composants ont une concentration définie.

2. Appareil selon la revendication 1, qui comprend une cellule de chargement pour la détection de la masse du développateur dans le bain de mélange.

3. Méthode de préparation d'un développateur dont les composants ont une concentration définie grâce au mélange d'une solution de développement non diluée et d'eau pure, comprenant l'utilisation de l'appareil de préparation du développateur selon la revendication 1 ou 2, la réception et le mélange de la solution de développement non diluée et de l'eau pure dans le bain de mélange, la mesure de la concentration des composants du développateur contenus dans le développateur dans le bain de mélange au moyen du densitomètre ultrasonore, le contrôle du débit d'alimentation de la solution de développement non diluée et/ou de l'eau pure dans le bain de mélange par l'introduction du signal de sortie du densitomètre ultrasonore dans le moyen de contrôle du débit pour donner un développateur dont les composants ont une concentration définie dans le bain de mélange et l'admission du développateur dans la cuve de stockage et sa conservation dans cette cuve.

4. Méthode selon la revendication 3, dans laquelle le signal de sortie du densitomètre ultrasonore et le signal de sortie de la eellule de chargement sont introduits dans le moyen de contrôle du débit.

5. Appareil selon la revendication 1 ou méthode de préparation d'un développateur selon la revendication 3 ou 4, dans lesquels la solution de développement non diluée est une solution aqueuse d'hydroxyde de tétraméthylammonium.
